# EUROPEAN PATENT SPECIFICATION

(11) **EP 1 735 479 B1**
(45) Date of publication and mention of the grant of the patent: **12.09.2012**
(21) Application number: 04806130.3
(22) Date of filing: 17.12.2004
(51) Int. Cl.: C23C 16/40, C03C 17/245

(54) **THERMOCHROMIC COATINGS**
THERMOCHROME BESCHICHTUNGEN
REVETEMENTS THERMOCHROMIQUES

(30) Priority: 17.12.2003 GB 0329213; 23.03.2004 GB 0406452
(43) Date of publication of application: 27.12.2006
(73) Proprietor: UNIVERSITY COLLEGE LONDON, London WC1E 7HN (GB)
(72) Inventor: PARKIN, Ivan, Milton Keynes MK15 8AW (GB); MANNING, Troy, Stockpot SK4 4NB (GB)
(74) Representative: Jackson, Richard Eric
(86) International application number: PCT/GB2004/005328
(87) International publication number: WO 2005/059201

(56) References cited:
- MANNING TROY D ET AL: "Atmospheric pressure chemical vapour deposition of tungsten doped vanadium(IV) oxide from VOCl3, water and WCl6" J. MATER. CHEM.; JOURNAL OF MATERIALS CHEMISTRY AUG 21 2004, vol. 14, no. 16, 21 August 2004 (2004-08-21), pages 2554-2559, XP002321259
- MANNING T D ET AL: "Intelligent window coatings: atmospheric pressure chemical vapor deposition of tungsten-doped vanadium dioxide" CHEMISTRY OF MATERIALS AMERICAN CHEM. SOC USA, vol. 16, no. 4, 29 January 2004 (2004-01-29), pages 744-749, XP002321260 ISSN: 0897-4756
- MANNING, T. D. ET AL: "Tungsten doped vanadium oxide thin films by atmospheric pressure chemical vapour deposition" PROCEEDINGS - ELECTROCHEMICAL SOCIETY , 2003-8(CHEMICAL VAPOR DEPOSITION XVI AND EUROCVD 14, VOLUME 2), 777-782 CODEN: PESODO; ISSN: 0161-6374, August 2003 (2003-08), XP009045279
- SOBHAN M A ET AL: "Thermochromism of sputter deposited WxV1-xO2 films" SOLAR ENERGY MATERIALS AND SOLAR CELLS, ELSEVIER SCIENCE PUBLISHERS, AMSTERDAM, NL, vol. 44, no. 4, 15 December 1996 (1996-12-15), pages 451-455, XP004065717 ISSN: 0927-0248 cited in the application
- MANNING, TROY D. ET AL: "Intelligent window coatings : atmospheric pressure chemical vapour deposition of vanadium oxides" JOURNAL OF MATERIALS CHEMISTRY , 12(10), 2936-2939 CODEN: JMACEP; ISSN: 0959-9428, 2002, XP002321262 cited in the application

## Description

### TECHNICAL FIELD

This invention relates to the use of atmospheric pressure chemical vapour deposition (APCVD) for producing films of thermochromic transition metal-doped vanadium (IV) oxide. The invention also relates to methods for the production of coatings of thermochromic transition metal-doped vanadium (IV) oxide and coated substrates, such as glass substrates comprising a coating of thermochromic transition metal-doped vanadium (IV) oxide.

### BACKGROUND OF THE INVENTION

Vanadium (IV) oxide (VO₂) is a technologically important material based on upon its ability to undergo a fully reversible metal-to-semiconductor phase transition. The conversion of the low temperature monoclinic phase VO₂(M) to the high temperature rutile phase [1] VO₂(R) is associated with significant changes in electrical conductivity [2] and optical properties [3] in the near-IR region. VO₂(R) is a semi-metal, reflecting a wide range of solar wavelengths. VO₂(M) is a semiconductor and reflects considerably less energy. VO₂ having such a reversible metal-to-semiconductor phase transition is said to be thermochromic.

These properties have led to suggestions of using VO₂ in data storage [4 & 5], infrared modulators [6] and intelligent window coatings, *i.e.* windows which respond to an environmental stimulus [7 & 8]. For example, the use of VO₂ coatings in glazing could allow the glazing to become more reflective with increasing temperature, thus reducing solar gain on hot days and decreasing air conditioning costs.

However, in order for VO₂ coatings to be practically useful in these applications, the phase transition temperature between the monoclinic phase and the rutile phase (also referred to as the thermochromic switching temperature) should ideally be just above room temperature, *i.e.* about 25-30°C. Other applications, such as for night vision apparatus, require VO₂ having a thermochromic switching temperature below room temperature, *i.e.* below 25°C.

Unfortunately, the thermochromic switching temperature of VO₂ itself is 68°C, meaning that unmodified VO₂ is not a practical solution for the above mentioned applications. Researchers have therefore developed techniques for reducing the thermochromic switching temperature of VO₂, the most efficient of which has been doping tungsten ions into the VO₂ lattice using sol-gel [9 & 10] and physical vapour deposition methods [11 & 12]. However, these known techniques are slow, are not compatible with large area glass manufacture and are unsuitable for incorporating into conventional float glass production lines as they require off production line manufacture, such as cutting the glass before deposition.

Manning, T. D. et al.: "Tungsten doped vanadium oxide thin films by atmospheric pressure chemical vapour deposition" Proceedings - Electrochemical society, 2003-8 (Chemical Vapour Deposition XVI and EUROCVD 14, Vol 2), page 777-782, August 2003., describes an APCVD process for depositing W-doped VO₂ thermochromic coatings on glass, where the lowest switching temperature obtained was 46°C.

It is an object of the invention to provide improvements in the production of coatings and films of thermochromic transition metal-doped vanadium (IV) oxide. It is a further object of the invention to provide improved transition metal-doped vanadium (IV) oxide and improved transition metal-doped vanadium (IV) oxide coatings and films.

### DISCLOSURE OF THE INVENTION

The inventors have discovered that the use of atmospheric pressure chemical vapour deposition (APCVD) provides improvements in methods for producing films and coatings of thermochromic transition metal-doped VO₂. The APCVD methods of the invention can be easily integrated into float glass production lines and allow fast growth times of the films and coatings. The invention also provides thermochromic transition metal-doped VO₂ films and coatings having improved mechanical properties, such as improved adhesion to a substrate and integrity of the film during handling, than those obtained by prior art methods. The inventors have also discovered improved thermochromic - transition metal-doped VO₂ films and coatings having thermochromic switching temperatures compatible with applications such as data storage, infrared modulators and intelligent window coatings.

In one aspect of the invention there is provided the use according to claim 1 of APCVD for producing a film of thermochromic transition metal-doped vanadium (IV) oxide on a substrate.

In particular, the invention provides a method according to claim 3 of producing a film of thermochromic transition metal-doped vanadium (IV) oxide on a substrate by atmospheric pressure chemical vapour deposition (APCVD) comprising the steps of:
(i) reacting together (a) a vanadium precursor (b) a transition metal dopant precursor and (c) an oxygen precursor in an atmospheric pressure chemical vapour deposition reactor to form thermochromic transition metal-doped vanadium (IV) oxide; and
(ii) depositing the thermochromic transition metal-doped vanadium (IV) oxide onto the substrate.

The APCVD methods of the invention allow the incorporation of higher tungsten doping of the VO₂ lattice and consequently a lower thermochromic switching temperature. In another aspect of the invention, thermochromic transition metal-doped vanadium (IV) oxide having an atom% transition metal dopant of about 1.9% or more is made. The invention also makes thermochromic transition metal-doped vanadium (IV) oxide having a thermochromic switching temperature from about 15°C to about 40°C, preferably from about 25°C to about 30°C.

Preferably, the transition metal dopant is tungsten. The invention also makes thermochromic yellow-brown tungsten-doped vanadium (IV) oxide.

Products such as data storage devices infrared modulators and intelligent windows, *i.e.* windows which respond to an environmental stimulus such as heat[13 & 14], can be made using the method of the invention.

### Detailed Description

The inventors have discovered a coating film, whose transmission properties vary depending on the ambient temperature. When coated on glass, these films provide a window whose optical properties may be varied without the need for an external driver. The coatings of the present invention are based upon Vanadium (IV) oxide (VO₂) which is a technologically important material with many potential advanced applications including data storage and infrared modulators. However these applications are based upon a fully reversible metal-to-semiconductor phase transition at 68°C. The low temperature monoclinic phase converts to the high temperature rutile phase and is associated with dramatic changes in electrical conductivity and optical properties in the near-IR region. VO₂(R) is a semi-metal, reflecting a wide range of solar wavelengths. VO₂(M) is a semiconductor and reflects significantly less energy. The use of VO₂ in glazing applications has been discussed, however for VO₂ thin films to become practically useful, the thermochromic switching temperature must be reduced from 68°C.

Atmospheric pressure chemical vapour deposition (APCVD) is an excellent method for applying thin films to glass substrates. The process can be easily integrated into float glass production lines, and has fast growth times. In one embodiment, this invention details the formation of tungsten-doped VO₂ from the APCVD reaction of VCl₄, water and a tungsten ethoxide precursor. It is shown that tungsten can be doped into VO₂ in order to generate a decrease in its thermochromic phase transition and that a maximum tungsten loading of approximately 5% can be obtained using the tungsten ethoxide precursor. The films display a reduced metal-to-semiconductor transition temperature compared to undoped VO₂.

In a second embodiment, this invention details the formation of tungsten-doped VO₂ from the APCVD reaction of VOCl₃, H₂O and WCl₆ precursors. Thin films of thermochromic VO₂ doped with up to 3 atom% tungsten were prepared on glass substrates from the APCVD reaction of VOCl₃, H₂O and a WCl₆.

### APCVD

APCVD is a well known technique for producing *inter alia* doped silicon dioxide and has also been used successfully to produce a single phase of VO₂ from VCl₄ and water [15]. It has not, however, been utilised in producing doped VO₂.

Known APCVD apparatuses include the SierraTherm™ 5500 Series Atmospheric Pressure CVD Systems. A preferred APCVD apparatus, is described in reference [15].

### Transition Metal-Doped Vanadium (IV) oxide

The transition metal dopant maybe any transition metal which is not vanadium having a valency of at least 4. Preferred transition metals are those in group 4 (*e.g.* titanium), group 5 (*e.g.* tantalum and niobium, especially niobium) and group 6 (*e.g.* molybdenum and tungsten, especially tungsten). Group 5 and 6 transition metals are more preferred, with tungsten being particularly preferred. The transition metal dopant forms a solid solution with the vanadium (IV) oxide which is thermochromic.

Other transition metals useful in the present invention are the lanthanides.

In further embodiments, non-transition metal dopants, such as lead and tin, may also be useful in the invention in place of the transition metal dopants.

It is believed that the transition metal-doped vanadium (IV) oxide of the invention is a solid solution of the formula V_{1-*x*}T*ₓ*O₂, where T is a transition metal dopant and 0 < *x* < 1. As used herein, the atom% transition metal dopant is equal to the percentage of transition metal dopant and vanadium atoms which are transition metal dopant atoms (100(*x*/[{1-*x*}+{*x*}]), *i.e.* 100*x*).

The transition metal-doped vanadium (IV) oxide of the invention is doped such that x>0.

Preferably, *x* is less than or equal to *x1*, where *x1* is 0.05 or less, *e.g.* 0.045, 0.04, 0.035, 0.030, 0.025, 0.025, 0.023, 0.022, 0.021, 0.020 or 0.019. It is especially preferred that *x1* is 0.03 *(i.e.* 3 transition metal dopant atom%).

Preferably, *x* is more than or equal to *x*2, where *x*2 is 0.005 or more, *e.g.* 0.01, 0.012, 0.013, 0.014, 0.015 or 0.016. It is also preferred in some embodiments that *x*2 is 0.02.

In one embodiment of the present invention, it is preferred that the thermochromic switching temperature is from about 15°C to about 40°C, more preferably from about 20°C to about 35°C, more preferably from about 25°C to about 30°C, *e.g.* from 25°C to 30°C. In another embodiment of the present invention, it is preferred that the thermochromic switching temperature is below about 25°C (*e.g.* below 25°C), but preferably also above or equal to about 5°C.

It has been discovered by the inventors that incorporation of tungsten caused a reduction in the VO₂ thermochromic switching temperature of about 19°C per tungsten atom%. In one embodiment, it is preferred that *x*4≤*x*≤*x*3 where *x*3 is 0.023 or less, *e.g.* 0.022, 0.021, 0.020 or 0.019, and *x*4 is 0.012 or more, *e.g.* 0.013, 0.014, 0.015 or 0.016. A preferred range of *x* in this embodiment is 0.012 ≤ *x* ≤ 0.023, more preferably 0.013 ≤ *x* ≤ 0.022, more preferably 0.014 ≤ *x* ≤ 0.021, more preferably 0.015 ≤ *x* ≤ 0.020, still more preferably 0.016 ≤ *x* ≤ 0.019.

A particularly preferred tungsten-doped vanadium (IV) oxide has a thermochromic switching temperature of 29°C obtained with 1.9 atom% tungsten (*i.e. x*=0.019).

In another embodiment, it is preferred that *x* is more than or equal to 0.016. Preferably x is also less than or equal to 0.031, more preferably less than or equal to 0.030.

In some embodiments, the transition metal-doped vanadium (IV) oxide of the invention contains no chlorine at a 0.5 atom% detection limit.

In some embodiments, the transition metal-doped vanadium (IV) oxide of the invention shows peaks for oxygen, vanadium, tungsten, silicon, carbon and nitrogen in X-ray Photoelectron Spectroscopy (XPS) analysis. If necessary, carbon and nitrogen may be removed from the surface by etching.

### Precursors

The vanadium, transition metal dopant and oxygen precursors are reactable in an APCVD reactor to form transition metal-doped vanadium (IV) oxide.

It has been discovered that (i) the temperature of the reaction of the precursors in the APCVD reactor and (ii) the molar ratio of vanadium in the vanadium precursor to oxygen in the oxygen precursor are critical parameters for ensuring that the precursors react together to form thermochromic transition metal-doped vanadium (IV) oxide.

In particular, the precursors must be reacted together in the APCVD reactor at a temperature of 500°C or more, preferably from 500°C to 660°C, still more preferably from 550°C to 650°C. When the transition metal precursor is VCl₄, it is particularly preferred that the precursors are reacted together in the APCVD reactor at a temperature of 550°C or more. When the transition metal precursor is VOCl₃, it is particularly preferred that the precursors are reacted together in the APCVD reactor at a temperature of 600°C or more.

Furthermore, the molar ratio of vanadium in the vanadium precursor to oxygen in the oxygen precursor must be at most 1:1, preferably from 1:1 to 1:60, more preferably from 1:1 to 1:5. It has been discovered that if the temperature is less than 500°C and the molar ratio of vanadium in the vanadium precursor to oxygen in the oxygen precursor is greater than 1:1, the precursors do not react to form a thermochromic solid solution of transition metal-doped vanadium (IV) oxide and in many instances form a non-thermochromic mixture of vanadium (IV) oxide and transition metal oxide.

It has also been discovered that the amount of transition metal precursor is not critical to the invention. This is surprising since it could not have been predicted that the tungsten precursor would not have had an effect on the phase of the doped vanadium (IV) oxide which is obtained in reaction. In one embodiment, the vanadium, transition metal dopant and oxygen precursors are VCl₄, W(OC₂H₅)₆ and H₂O, respectively.

In another embodiment, the vanadium, transition metal dopant and oxygen precursors are VOCl₃, WCl₆ and H₂O, respectively.

It is generally preferred that the precursors are volatile, *i.e.* they have a high vapour pressure at temperatures below the decomposition temperature of the precursor. Volatile precursors lead to improved doping of the vanadium (IV) oxide lattice and hence lower thermochromic switching temperatures.

### Vanadium Precursor

The vanadium precursor may be any precursor containing vanadium capable of reacting in an APCVD reactor with the transition metal dopant and oxygen precursors and providing vanadium to form transition metal-doped vanadium (IV) oxide.

To promote reaction of the vanadium precursor with the other precursors in the APCVD reactor, the vanadium precursor should preferably have a high vapour pressure at temperatures below the decomposition temperature of the precursor. More preferred vanadium precursors have a vapour pressure of at least 120 mmHg in the vanadium precursor bubbler of the APCVD apparatus at temperatures below the decomposition temperature of the precursor.

Preferred vanadium precursors are vanadium complexes having at least one ligand (and preferably all ligands) selected from the group consisting of alkoxide (*e.g.* C₁₋₄alkoxide such as ethoxide), halide (*e.g.* fluoride, chloride, bromide, iodide, preferably chloride), CO, alkyl (*e.g.* C₁₋₄alkyl such as methyl, ethyl *etc*.), amide (*e.g.* R¹CONR¹₂, where each R¹ is independently H or C₁₋₄alkyl), aminyl (*e.g.* NR¹₂ where R¹ is defined as above) and acac (2,4-pentanedione).

More preferred vanadium precursors comprise ligands, such as Cl, which are easily substituted by the oxygen of the oxygen precursor. Preferred vanadium precursors are therefore VCl₄ and VOCl₃.

Other preferred vanadium precursors are V(acac)₃, V(acac)₄, VO(acac)₂, V(NMe₂)₄, V(NEt₂)₄ and VO(OiPr)₃.

### Transition Metal Dopant Precursor

The transition metal dopant precursor may be any precursor containing tungsten capable of reacting in an APCVD reactor with the vanadium and oxygen precursors and providing the transition metal to form transition metal-doped vanadium (IV) oxide.

To promote reaction of the transition metal dopant precursor with the other precursors in the APCVD reactor, the transition metal dopant precursor should preferably have a high vapour pressure at temperatures below the decomposition temperature of the precursor. More preferred transition metal dopant precursors have a vapour pressure of at least 25 mmHg in the transition metal dopant precursor bubbler of the APCVD apparatus at temperatures below the decomposition temperature of the precursor.

Preferred transition metal dopant precursors are transition metal complexes having at least one ligand (and preferably all ligands) selected from the group consisting of alkoxide (*e.g.* C₁₋₄alkoxide such as ethoxide), halide (*e.g.* fluoride, chloride, bromide, iodide, preferably chloride), CO, alkyl (*e.g.* C₁₋₄alkyl such as methyl, ethyl *etc*.), amide (*e.g.* R¹CONR¹₂, where each R¹ is independently H or C₁₋₄alkyl), aminyl (*e.g.* NR¹₂ where R¹ is defined as above) and acac (2,4-pentanedione).

Preferred tungsten precursors are W(OEt)₅, W(OEt)₆, WCl₆, W(CO)₆, WF₆, W(NMe₂)₆ and W(NEt₂)₆.

One preferred tungsten dopant precursor is W(OEt)₆.

An especially preferred tungsten dopant precursor is WCl₆. This precursor is particularly preferred since it has been shown to give superior coverage of the substrate. WCl₆ has been shown to be a superior precursor for APCVD allowing higher tungsten doping of the VO₂ lattice, thus allowing much lower thermochromic switching temperatures. This superiority is thought to arise from the relatively high vapour pressure of WCl₆.

The amount of transition metal-doped into the vanadium (IV) oxide may be controlled by varying the molar ratio of transition metal in the transition metal precursor to vanadium in the vanadium precursor in the APCVD reaction, *i.e.* increasing the amount of transition metal to vanadium in the APCVD reaction increases the transition metal doping. Typical molar ratios of transition metal in the transition metal dopant precursor to vanadium in the vanadium precursor are from about 1:25 to about 1:1, e.g. from about 1:21 to about 1:1.5.

### Oxygen Precursor

The oxygen precursor may be any precursor containing oxygen capable of in an APCVD reactor with the transition metal dopant and vanadium precursors and providing oxygen to form transition metal-doped vanadium (IV) oxide. Preferably, the oxygen precursor contains neither vanadium nor transition metal, *i.e.* it is neither a vanadium precursor nor a transition metal precursor.

To promote reaction of the oxygen precursor with the other precursors in the APCVD reactor, the oxygen precursor should preferably have a high vapour pressure at temperatures below the decomposition temperature of the precursor. More preferred oxygen precursors have a vapour pressure of at least 600 mmHg in the oxygen precursor bubbler of the APCVD apparatus at temperatures below the decomposition temperature of the precursor.

Preferred oxygen precursors are selected from the group consisting of alcohols (*e.g.* C₁₋₄ alcohols such as methanol and ethanol), carboxylic acid (*e.g.* C₁₋₄ carboxylic acid such as ethanoic acid), ethers (*e.g.* C₁₋₄-O-C₁₋₄ ethers), acid anhydrides (*e.g.* R¹-C(O)-O-C(O)-R¹, where each R¹ is independently H or C₁₋₄alkyl), molecular oxygen and air.

One preferred oxygen precursor is H₂O.

Another preferred oxygen precursor is ethyl acetate.

### The Film

The tungsten-doped vanadium (IV) oxide films of the invention preferably have a thickness from 25 nm to 1000 nm, preferably from 50 nm to 500 nm, more preferably from 100 nm to 400 nm.

In some embodiments, the films of the invention may have worm-like structures with a width of about 10nm and a length between 100 and 800 nm. Typically, substantially all these structures are perpendicular to the substrate.

### The Substrate

Provided the substrate is capable of having a film of transition metal-doped vanadium (IV) oxide deposited on its surface by APCVD, *e.g.* it is capable of withstanding the temperature of the APCVD, the substrate is not critical to the invention.

However, preferred substrates are glass substrates, *e.g.* glass slides, films, panes and windows *etc.* Particularly preferred glass substrates have about a 50nm thick SiO₂ barrier layer to stop diffusion of ions from the glass into the film of transition metal-doped vanadium (IV) oxide.

Other preferred substrates are silicon, SiO₂ or metal (*e.g.* aluminium or copper) substrates. Such substrates may be in the form of slides, films, panes or windows *etc.*

Substrates coated with a film of transition metal-doped vanadium (IV) oxide of the invention may be used in data storage, infrared modulators and intelligent window coatings.

The invention therefore provides a data storage device (*e.g.* a cassette, disk, compact disc (CD), digital versatile disk (DVD) *etc.*) comprising a data recording medium comprising a coated substrate coated with a film of transition metal-doped vanadium (IV) oxide of the invention.

The invention also provides an intelligent window system, *i.e.* a window which responds to an environmental stimulus such as heat [16 & 17], *e.g.* without an external driver, comprising a glass substrate coated with a film of transition metal-doped vanadium (IV) oxide of the invention.

The invention also provides infrared modulators, *e.g.* a devices for controlling the amount of infrared radiation impinging on a detector such as those mentioned in [6], comprising a substrate coated with a film of transition metal-doped vanadium (IV) oxide of the invention.

### General

The term "comprising" encompasses "including" as well as "consisting" *e.g.* a composition "comprising" X may consist exclusively of X or may include something additional *e.g.* X + Y.

The word "substantially" does not exclude "completely" *e.g.* a composition which is "substantially free" from Y may be completely free from Y. Where necessary, the word "substantially" may be omitted from the definition of the invention.

The term "about" in relation to a numerical value x means, for example, *x*±10%.

### BRIEF DESCRIPTION OF DRAWINGS

Figure 1 shows an edge-on SEM of typical tungsten-doped VO₂ to determine film thickness.
Figure 2 shows a Raman spectra of a) undoped VO₂ and b) tungsten-doped VO₂.
Figure 3 shows a glancing angle XRD of tungsten-doped VO₂ thin film on glass substrate.
Figure 4A shows an XPS depth profile of V3d and W4f region.
Figure 4B shows a Rutherford backscattering spectrum of tungsten-doped VO₂ on glass substrate.
Figure 5 shows a Raman spectra of a tungsten-doped VO₂ thin film on glass at 25 °C to 50 °C.
Figure 6 shows a Reflectance-transmittance spectra of tungsten-doped VO₂ thin film above and below the MST transition temperature.
Figure 7 shows transmittance at 2.5 µm against temperature for tungsten-doped VO₂ thin films.
Figure 8 shows an XRD pattern of tungsten-doped VO₂(M).
Figure 9 shows an XRD pattern of tungsten-doped VO₂(R).
Figure 10 shows an SEM of tungsten-doped VO₂.
Figure 11 shows deconvoluted O1s and V2p_{3/2} XPS peaks for tungsten-doped VO₂.
Figure 12 shows deconvoluted W4f XPS peaks for tungsten-doped VO₂.
Figure 13 shows XRD patterns at different temperatures for tungsten-doped VO₂.
Figure 14 shows Raman spectra at different temperatures for W:VO₂(R) to W:VO₂(M).
Figure 15 shows the relationship between W content of VO₂ thin film to thermochromic transition temperature.
Figure 16 shows reflectance-transmittance spectra below and above the thermochromic transition temperature for tungsten-doped VO₂ thin film.

### MODES FOR CARRYING OUT THE INVENTION

All chemical vapour deposition (CVD) studies were performed on a custom built apparatus using a previously described procedure [15]. Nitrogen (99.999%, BOC UK) was used as the system gas in all CVD reactions.

The substrate in all CVD reactions was float glass that had a 50 nm thick SiO₂ barrier layer to stop diffusion of ions from the glass into the film. The glass had dimensions 15 cm x 4.5 cm x 0.3 cm and was cleaned before use by wiping with a water-soaked tissue, and then a propan-2-ol soaked tissue and then rinsed with propan-2-ol. It was allowed to dry in air prior to mounting in the CVD chamber.

### Example 1 (vanadium chloride, W(OC₂H₅)₆ and water)

### Film Preparation

Vanadium(IV) chloride (99%, Aldrich, UK) and [W(OC₂H₅)₆], (99.9% Alfa Aesar UK) were placed into separate bubblers. Distilled water was injected into the plain-line gas-flow using a fixed rate syringe driver (1.33 cm min⁻¹) and a 2 cm³ syringe. A series of films were prepared by varying the carrier-gas flow-rate through the tungsten precursor bubbler and keeping all other conditions constant to those determined to produce undoped VO₂ films. The VCl₄ : H₂O ratio was between 1:5 and 1:10 for all CVD reactions, this was the condition previously determined to promote the growth of VO₂ thin films [15]. The tungsten precursor bubbler temperature was set to 190°C. The flow rate through the bubbler containing the tungsten precursor was required to be greater than 0.5 L min⁻¹ for significant vapour to be transported to the CVD reactor. A substrate temperature above 550 °C was required for formation of O₂ from VCl₄ and H₂O [15].

### Film Analysis

Analysis of the resulting films consisted of UV/vis, adhesion tests (scratch and abrasion resistance, Scotch tape test), vis/IR reflectance-transmittance, micro Raman spectroscopy, scanning electron microscopy and energy dispersive analysis of X-rays (SEM/EDX), glancing angle X-ray diffraction (GAXRD), X-ray photoelectron spectroscopy (XPS) and Rutherford backscattering spectroscopy (RBS). UV/vis absorption measurements were obtained on a Thermospectronic Helios a spectrometer between 300 - 1100 nm. Reflectance-transmittance measurements were performed on a Hitachi U4000 spectrophotometer between 240 nm and 2600 nm. Transmittance-temperature studies were performed on a Perkin Elmer 457 grating spectrometer set to 4000 cm⁻¹. Sample temperature was controlled by an aluminium temperature cell controlled by RS heaters, and Eurotherm temperature controllers and k-type thermocouples. Sample temperature was measured by a k-type thermocouple taped to the film surface. Raman spectroscopy was performed on a Renishaw 1000 spectrometer using a 632.8 nm laser at 2 mW and 50x magnification, sample temperature was controlled by a Linkam THMS600 variable temperature cell with a liquid nitrogen pump.

SEM images to determine film thickness were obtained on a Hitachi S-570 scanning electron microscope at 20 kV accelerating voltage. Energy dispersive analysis of X-rays (EDX) was performed on a Philips XL30 ESEM instrument using Inca analytical software (Oxford Instruments).

X-ray analysis of the films was determined on a Siemens D5000 machine using primary Cu K_{α} radiation at 1.5418 Å with a 1.5° incident angle. X-ray photoelectron spectrometry was performed on a VG ESCALAB 2201 XL instrument using monochromatic Al K_{α} X-rays with a pass energy of 50 eV. XPS data was analysed using CasaXPS software. Rutherford backscattered spectra were obtained using a 2 MeV accelerator, the analysing beam was 2 MeV He⁺ with the sample being analysed at normal incidence with a scattering angle of 168° in IBM geometry. Quark software was used for the simulation.

### Film Properties

Blue amorphous tungsten oxide films could be produced from the single source precursor [W(OC₂H₅)₆]. This agrees with the results of Riaz [18]. Thin films of tungsten-doped vanadium(IV) oxide were obtained from the atmospheric pressure chemical vapour deposition of VCl₄, [W(OC₂H₅)₆] and water at 550 °C to 650 °C. A summary of the conditions used to prepare the films and their properties is given in Table 1.

**Table 1**

| APCVD conditions used to prepare tungsten-doped VO₂ thin films from VCl₄, [W(OC**₂**H₅)₆] and water | | | | | |
|---|---|---|---|---|---|
| **W precursor bubbler flow rate / L min⁻¹ - temperature/°C** | **Reactor temperature / °C** | **Gas phase VCl₄ : H₂O ratio** | **Phase observed^{a}** | **Composition** | **Thermochromic transition temperature / °C** |
| 1.2 - 180 | 550 | 1:10.7 | VO₂ | | 45 |
| 1.0 - 184 | 600 | 1:10.2 | VO₂ | V_{0.98}W_{0 02}O₂ | 45^{d} |
| 1.0 - 185 | 600 | 1:9.2 | VO₂ | V_{0.95}W_{0 05}O₂ | 48 |
| 1.0 - 187 | 600 | 1:9.8 | VO₂ | V_{0.99}W_{0 01}O₂ | 42 |
| 1.0 - 188 | 600 | 1:10.2 | VO₂ | | 41 |
| 1.5 - 180 | 625 | 1:6.6 | unidentified | | None |
| 2.0 - 182 | 650 | 1:6.6 | VO₂ | | 57 |
| 2.0 - 182 | 650 | 1:7.0 | VO₂ | | 55 |
| 2.0 - 190 | 650 | 1:5.3 | VO₂ | | 45^{e} |
| 2.0 - 195 | 650 | 1:5.3 | VO₂ | | 60^{e} |
| 1.2 - 189 | 650 | 1:5.5 | VO₂ | | 48 |
| 0.8 - 194 | 650 | 1:4.8 | VO₂ | | Minimal |
| 0.8 - 190 | 650 | 1.48 | VO₂ | | 56 |
| 1.3 - 194 | 650 | 1:4 | VO₂ | V_{0.98}W_{0 02}O₂ | 49 |

| | | | | | |
|---|---|---|---|---|---|
| *^{a}* Determined by micro Raman spectroscopy and glancing angle XRD. *^{b}* Determined by RBS *^{c}* determined by XPS *^{d}* <200 nm in thickness *^{e}* Determined by micro Raman spectroscopy | | | | | |

The films were yellow in colour, passed the Scotch tape test, but were easily scratched and removed when rubbed with a tissue. One film had a deep blue area at the leading edge of the substrate which was identified as VO₂(B) by X-ray diffraction. This area did not show any thermochromic switching properties in the temperature range investigated (< 80°C). One other film was identified as V₂O₅ by Raman spectroscopy but could not be repeated, VO₂ being obtained in subsequent, similar experiments.

Film thickness, as measured by SEM imaging, was typically 300-400 nm. This was sufficiently thick to prevent the strain induced reduction in the transition temperature observed in films of <200 nm as observed by Maruyama and Ikuta [19]. Films that were particularly thin, as marked in Table 1, did show considerably lower thermochromic transition temperatures discordant with their tungsten content. Film morphology was that congruent with the island growth mechanism typical of films grown on highly nucleating substrates. The non-adherence of the films relates to the growth mechanism as the film atoms are more strongly bound to each other than the substrate [20].

The vanadium oxide phase of the films was determined by Raman microscopy and glancing angle X-ray diffraction. The tungsten content of the films was determined by X-ray photoelectron spectroscopy and Rutherford backscattering.

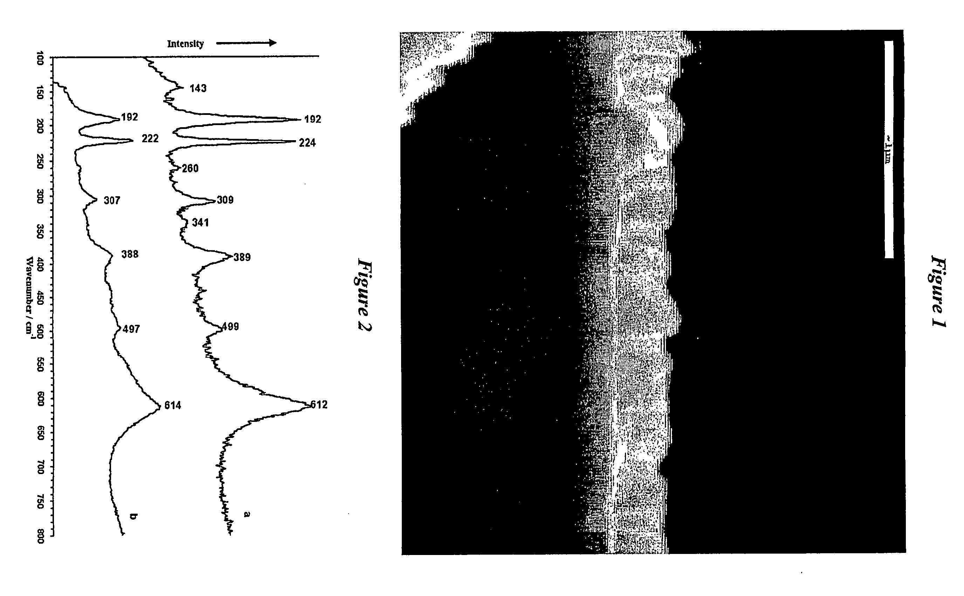

The main phase of vanadium oxide observed by Raman spectroscopy was monoclinic VO₂, the Raman spectra of which matched literature spectra [21, 22 & 23]. Some broadening of the Raman bands were observed for the doped vanadium oxide compared to the pure substance as shown in Figure 2. All Raman bands are assigned to an Ag symmetry mode [21, 22 & 23]. The broadening of the Raman bands is probably due to increased defects caused by the dopant ions in the lattice.

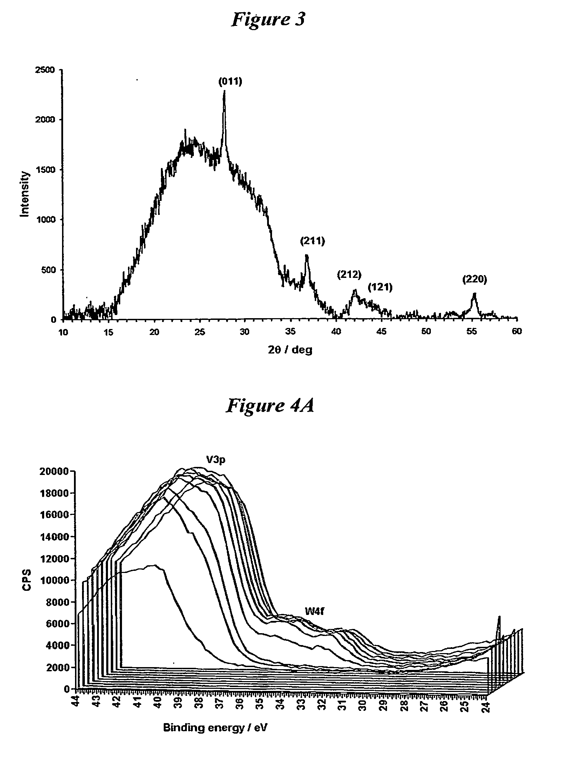

X-ray diffraction studies of the thin films confirmed that the films consisted of the monoclinic phase of VO₂ (Figure 3) matching database spectra (JCPDS file 43-1051). No prefered orientation was observed. XPS studies indicated the films did not contain chlorine contamination within the detection limits of the instrument (0.1 atom%). Also carbon contamination from the alkoxide precursor was not observed. A peak due to adsorbed carbon dioxide, which served as a peak position reference, was observed on the surface of the films, but was not observed after 30 seconds of argon etching.

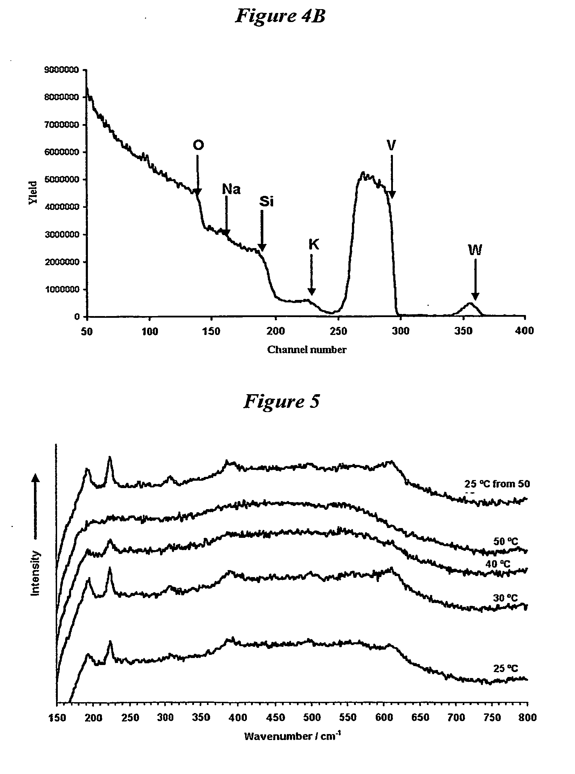

Depth profiling by XPS showed that the tungsten was segregated into the bulk of the film and was not incorporated in the surface layers of the film. Figure 4A illustrates the tungsten content of the film increasing with depth. The depth profiling results are confirmed by RBS modelling (Figure 4B). The contents of the tungsten ethoxide containing bubbler was checked after deposition and the tungsten precursor was not exhausted during deposition and no lines were blocked so it implies the tungsten is bulk segregated.

XPS was also used to elucidate the oxidation states of the ions present. It was found that in the tungsten containing layers of the thin films, vanadium was present as mostly V⁴⁺, with a V2p3/2 binding energy of 515.4 eV, and a reduced vanadium species, tentatively assigned as V³⁺ ions with a binding energy of 514 eV. A broadening of the V2p and V3p peaks towards lower binding energy is observed as etching progresses due to the preferential sputtering of oxygen, forming reduced vanadium species. This broadening increases markedly at layers containing tungsten, suggesting that the tungsten may also be influencing the oxidation state of the vanadium ions.

These observations agree with the theory of Tang *et al.* [24] that the V⁴⁺-V⁴⁺ pairs of the monoclinic phase are disrupted by tungsten doping forming a V³⁺-W⁶⁺ pair and a V³⁺-V⁴⁺ pair. This destabilises the semi-conducting monoclinic phase of VO₂ to lower the temperature at which the MST occurs. The preferential sputtering of oxygen prevented the quantification of the V⁴⁺ to V³⁺ ratio as the reduced species would be artificially higher.

Tungsten W4f_{7/2} and W4f_{5/2} peaks occurred at 32.6 eV and 34.8 eV respectively, agreeing with literature values for W⁴⁺ in WO₂ [25]. This is contrary to the theory of Tang *et al.* The amount of tungsten present in the films was related to the thermochromic transition temperature.

### Thermochromic Transition Temperature

The tungsten content of the films is taken to be that of the tungsten containing layers. Thermochromic transition temperature was taken to be the centre of the hysteresis curve as discussed by Burkhardt *et al.* [11].

To observe the MST phase transition by Raman microscopy, a heating cell was used to raise the temperature of the films on the glass substrates at a rate of 3°C min⁻¹. The cell was allowed to dwell at the chosen temperature for 10 minutes before the spectrum was obtained. A typical set of spectra are shown in Figure 5, where a tungsten content of 0.6% gave a transition temperature of below 50 °C.

These results follow the trend of the pure compound as investigated by Aronov *et al.* [22 & 23].

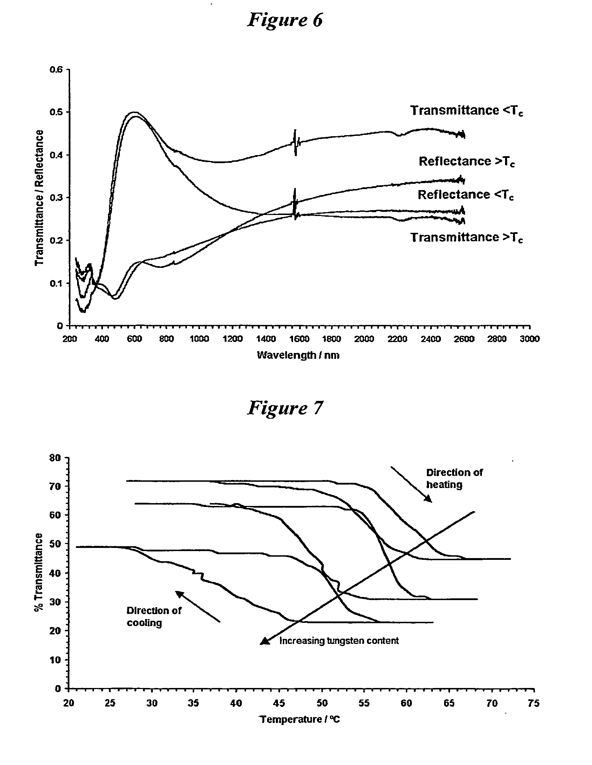

A measurement of the reflectance-transmittance spectra of the films below and above the metal-to-semiconductor transition, Figure 6, indicates the films display the properties required for intelligent window coating applications. Namely a dramatic decrease in IR transmittance and increase in IR reflectance but with little or no change in the visible region.

To observe the thermochromic transition temperature the change in transmittance of 2.5 µm infrared radiation was measured while the sample temperature was increased by 2 °C min⁻¹ and then allowed to cool naturally, some results of which are displayed in Figure 7.

The extent of the reduction in thermochromic transition temperature could be related to the tungsten content of the film as shown in Table 1 and Figure 5. A reduction of the thermochromic transition by 21°C / 1 % W was observed for the tungsten-doped VO₂ thin films prepared in this study. The maximum observed decrease in IR transmittance was 45 % on passing through the metal-to-semiconductor transition for a 1.2% W doped VO₂ film with a typical decrease in transmittance of 30% being observed.

### Example 2 (vanadium oxytrichloride, WCl₆ and water)

### Film Preparation

Vanadium(V) oxytrichloride (99.5 %, Strem, UK) and WCl₆, (99.9 % Strem, UK) were placed into separate bubblers. Distilled water was injected into the plain-line gas-flow using a fixed rate syringe driver (1.33 cm min⁻¹) and a 2 cm³ syringe. A series of films were prepared by varying the carrier-gas flow-rate through the tungsten precursor bubbler between 0.2 L min⁻¹ and 2.0 L min⁻¹. All other conditions were kept constant to previous work[26]. The gas phase VOCl₃ : H₂O concentration ratio was between 1:1 and 1:2 for all CVD reactions. The bubbler containing WCl₆ was set to 240°C.

Analysis of the resulting films consisted of UV/vis, adhesion tests (scratch and abrasion resistance, Scotch tape test), vis/IR reflectance-transmittance, micro Raman spectroscopy, scanning electron microscopy and energy dispersive analysis of X-rays (SEM/EDX), glancing angle X-ray diffraction (GAXRD) and X-ray photoelectron spectroscopy (XPS). UV/vis absorption measurements were obtained on a Thermospectronic Helios α spectrometer between 300-1100 nm. Reflectance-transmittance measurements were performed on a Hitachi U4000 spectrophotometer between 240 nm and 2600 nm. Transmittance-temperature studies were performed on a Perkin Elmer 457 grating spectrometer set to 4000 cm⁻¹. An aluminium temperature cell controlled by RS cartridge heaters, Eurotherm temperature controllers and k-type thermocouples was used to manipulate sample temperature. Sample temperature was measured by a k-type thermocouple taped to the film surface. Raman spectroscopy was performed on a Renishaw 1000 spectrometer using a 632.8 nm laser at 2 mW and 50x magnification, sample temperature was controlled by a Linkam THMS600 variable temperature cell with a liquid nitrogen pump. SEM images to determine film thickness were obtained on a Jeol JSM-6301F scanning electron microscope at 15 kV accelerating voltage. Samples were prepared by deeply scoring the film side of the substrate to cause shelling of the film and hence a distinct edge between the film and substrate. Energy dispersive analysis of X-rays (EDX) was performed on a Philips XL30 ESEM instrument using Inca analytical software (Oxford Instruments). X-ray analysis of the films was determined on a Siemens D5000 machine using primary Cu K_{α} radiation at 1.5418 Å with a 1.5° incident angle. Diffraction patterns at different temperatures were obtained at station 2.3 of the CCLRC synchrotron radiation source at Daresbury, UK using 1.2981 Å radiation with a 1.5° incident angle. The temperature was controlled using the aluminium sample holder described above. X-ray photoelectron spectrometry was performed on a VG ESCALAB 2201 XL instrument using monochromatic Al K_{α} X-rays with a pass energy of 50 eV. XPS data was analysed using CasaXPS software version 2.0.11.

Thin films of tungsten-doped vanadium oxide prepared by the APCVD reaction of vanadium(V) oxytrichloride, water and tungsten(VI) chloride were yellow-brown in colour and gave complete coverage of the substrate. Table 2 gives a summary of the conditions used to prepare the films and the results of the analyses. In all cases single phase VO₂ was obtained.

**Table 2**

| Conditions used to prepare tungsten-doped VO₂ thin films from the APCVD reaction of VOCl₃, H₂O and WCl₆. | | | | | | |
|---|---|---|---|---|---|---|
| **Reactor temp. / °C** | **Gas phase amount of WCl₆ / mol min⁻¹** | **Gas phase amount VOCl₃ / mol min⁻¹** | **Gas phase amount H₂O / mol min⁻¹** | **Phase from Raman and XRD** | **W atom% in film** | **Transition temperature ± hysteresis width / °C** |
| 650 | 0.002 | 0.014 | 0.026 | VO₂(M) | 0.6 | 43 ± 6 |
| 650 | 0.004 | 0.026 | 0.026 | VO₂(M) | 0.3 | 55 ± 7 |
| 650 | 0.008 | 0.024 | 0.026 | VO₂(M) | 1.2 | 35 ± 3 |
| 650 | 0.010 | 0.019 | 0.026 | VO₂(R) | 2.6 | 10^{(a)} |
| 650 | 0.001 | 0.021 | 0.026 | VO₂(M) | 0.4 | 55 ± 6 |
| 650 | 0.010 | 0.015 | 0.026 | VO₂(R) | 3.1 | 5^{(a)} |
| 650 | 0.006 | 0.017 | 0.026 | VO₂(M) | 0.9 | 41 ± 3 |
| 650 | 0.008 | 0.021 | 0.026 | VO₂(M) | 0.7 | 45 ± 6 |
| 650 | 0.009 | 0.020 | 0.026 | VO₂(M) | 1.9 | 29^{(a)} |

| | | | | | | |
|---|---|---|---|---|---|---|
| ^{a} Hysteresis width only measurable with T_{c} above 30 °C. | | | | | | |

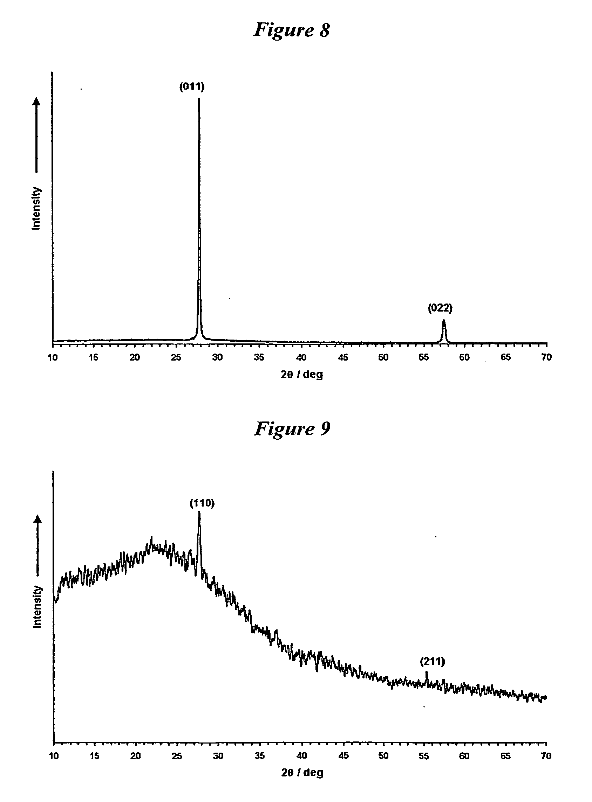

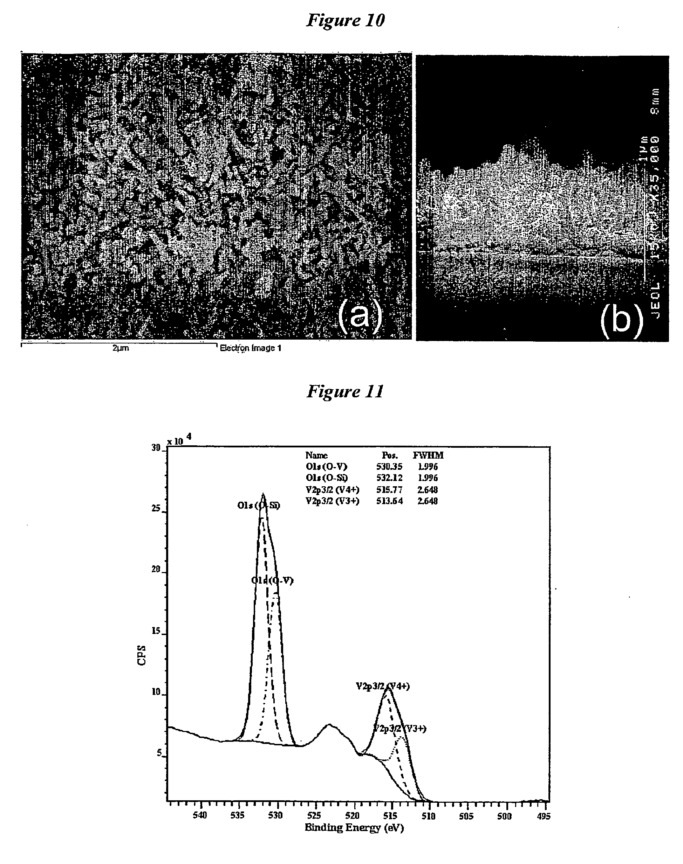

X-ray diffraction of the tungsten-doped VO₂ thin films prepared from VOCl₃, H₂O and WCl₆ films showed reflections at 27.8° and 57.5° (Figure 8) corresponding to the (011) and (022) planes of the monoclinic phase of VO₂ respectively. This strongly indicated that the films were preferentially orientated along the (011) plane. Insufficient reflections were observed for accurate cell parameters to be calculated and Miller indices were assigned by comparison to literature patterns [27]. The films containing sufficient tungsten so that the metal-to-semiconductor phase transition occurred below room temperature showed reflections at 27.7° and 55.4°. These reflections corresponded to the (110) and (211) planes of the tetragonal phase of VO₂ respectively as shown in (Figure 9). No reflections due to oxides of tungsten were observed, suggesting that the tungsten did not form a separate phase but formed a solid solution with the VO₂. Scanning electron microscopy (Figure 10) showed thin worm-like structures, with a width of about 10 nm and a length varying between 100 and 800 nm, almost perpendicular to the substrate. The morphology of the films may explain the preferred orientation observed in the X-ray diffraction patterns of the tungsten-doped VO₂ thin films. This is unusual growth morphology and is an extreme form of the Volmer-Weber island growth mechanism.

X-ray photoelectron spectroscopy was used to determine the composition of the tungsten-doped VO₂ thin films prepared from VOCl₃, H₂O and WCl₆. Wide range survey spectra of the surface of the films showed XPS peaks for oxygen, vanadium, tungsten, silicon, carbon and nitrogen. No chlorine was detected in any of the tungsten-doped VO₂ thin films. Nitrogen was an atmospheric contaminant and carbon could be attributed to hydrocarbons from the oil diffusion pump of the vacuum chamber.

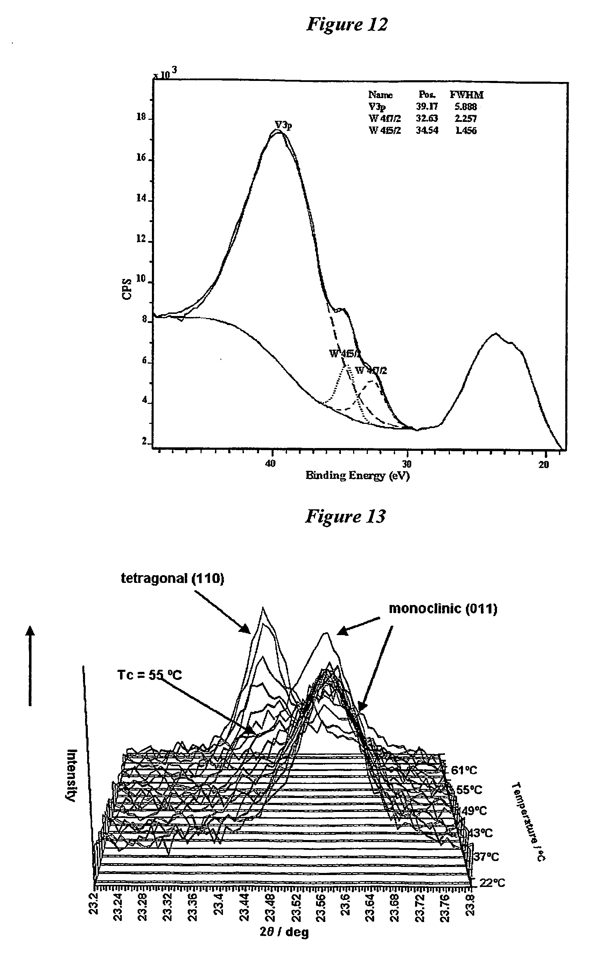

Both surface contaminants were easily removed by argon ion etching. The peaks due to silicon were from the glass substrate that was exposed through pinhole defects in the deposited vanadium oxide films. Quantitative analysis was performed on the first etched layer of the film using the O1s, V2p and W4d_{3/2} XPS peaks. Oxidation state analysis was performed on the O1s, V2p and W4f XPS peaks of the surface layer to avoid possible problems with changes in valence caused by argon ion etching. These peaks were chosen because literature assignments were more readily available [28] & [29]. The lowest amount of tungsten introduced into the VO₂ lattice was 0.3 atom% and the highest was 3.1 atom%. Tungsten was found to be homogeneously distributed throughout the vanadium oxide films as indicated by depth profiling analysis. High-resolution analysis of the O1s and V2p XPS peaks (Figure 11) indicated that the vanadium was present in two forms, V⁴⁺ with a binding energy of 515.8 eV and V³⁺ with a binding energy of 513.6 eV. The O1s peak could be deconvoluted to two components relating to oxygen bound to a transition metal with a binding energy of 530.4 eV, and oxygen bound to silicon from the glass substrate with a binding energy of 532.1 eV. Deconvolution of the W4f peaks (Figure 12) indicated that the tungsten was present as W⁴⁺, with W4f_{5/2} and W4f_{7/2} binding energies of 34.5 and 32.6 eV respectively. This indicated that the tungsten had undergone a reduction when incorporated into the VO₂ lattice. If the reduction of tungsten was caused by it's incorporation into the VO₂ lattice, the presence of V⁵⁺ due to charge compensation would be expected. The reduction of the tungsten ions was most likely to have occurred before film formation. If tungsten(III) species were formed prior to the incorporation of tungsten into the vanadium oxide film (tungsten(III) chloride species are known [30]), then the formation of V³⁺ is easily explained. The reduction of one V⁴⁺ cation by each W³⁺ species could form the detected W⁴⁺ and V³⁺ cations. Alternatively, tungsten(IV) species could be formed during gas phase or surface reactions and then migrate to a nucleation site. This would not explain the presence of V³⁺ in the thin film. The formation of reduced vanadium ions in tungsten-doped VO₂ thin films helps to explain the observed thermochromic transition temperatures of the films. The low temperature semiconducting phase would be destabilised by the presence of the V³⁺ and thus reduce the thermochromic transition temperature. These observations are complementary to the theory Tang *et al.* [24], who suggested that the formation of V³⁺ on tungsten doping causes a destabilisation of the monoclinic phase of VO₂ and reduces the metal-to-semiconductor transition temperature.

Analysis of the thermochromic properties of the tungsten-doped VO₂ thin films prepared from VOCl₃, H₂O and WCl₆ were examined by X-ray diffraction, Raman spectroscopy and visible/IR reflectance-transmittance spectroscopy. The thermochromic transition temperatures of the thin films were measured by their infrared transmittance with varying temperature. The X-ray diffraction at different temperatures of a 0.7 atom% tungsten-doped VO₂ thin film was preformed to reveal the monoclinic (011) reflection transforming into the tetragonal (110) reflection when the temperature was increased (Figure 13). The first order transition was clearly observed with both phases of VO₂ present as the metal-to-semiconductor transition occurred. The reversibility of the transition was also displayed with the monoclinic (011) reflection returning when the sample was cooled back to room temperature. The transition temperature for the 0.7 atom% tungsten-doped VO₂ thin film was taken to be 55°C, where the monoclinic and tetragonal reflections were of equal intensity.

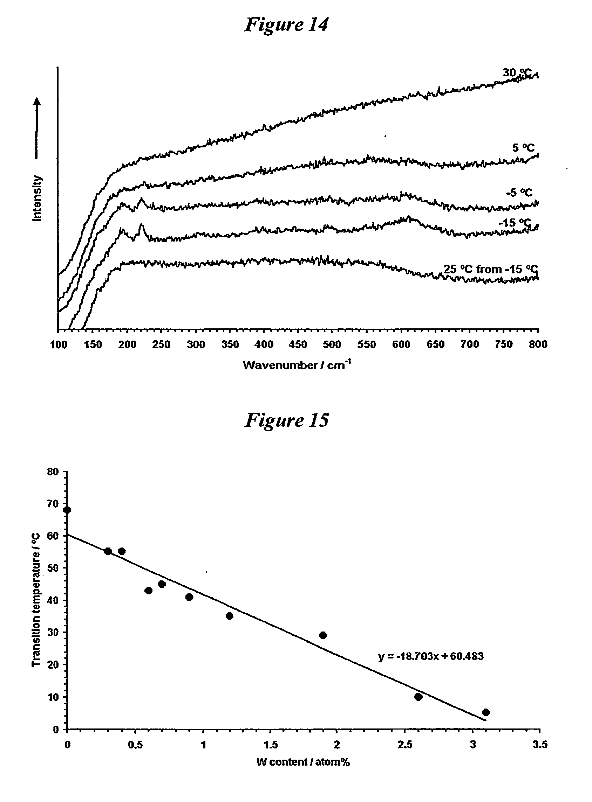

When the tungsten content of a VO₂ thin film was above 2 atom% the transition temperature was below 25°C. The Raman spectra at temperatures down to -15°C, for a 3.1 atom% tungsten-doped VO₂ thin film deposited from VOCl₃, H₂O and WCl₆ is shown in Figure 14. There were no Raman bands apparent at 30°C, the broad feature at 555 cm⁻¹ usually observed in the Raman spectrum of the high temperature phase of VO₂ was not seen. Raman bands for oxides of tungsten were not observed, reinforcing the supposition that the tungsten formed a solid solution with the VO₂ and not a separate phase. On cooling to 5°C a very weak band at 221 cm⁻¹ was seen, as was the broad feature at 555 cm⁻¹, indicating the film was at the transition point. By cooling further to -5°C more Raman bands for the monoclinic phase of VO₂ were observed, bands at 195, 222 and 610 cm⁻¹ were present in the spectrum. At -15°C an almost complete set of Raman bands for monoclinic VO₂ were observed, with peaks at 195, 222, 307, 500 and 610 cm⁻¹. When the film was heated back up to room temperature no Raman bands were observed in the spectrum indicating that the material had returned to the high temperature, metallic phase of VO₂. This was an important result showing the ability of the VOCl₃, H₂O and WCl₆ APCVD system to prepare tungsten-doped VO₂ with tungsten contents high enough to give thermochromic switching temperatures well below room temperature.

When the transition temperature was plotted against the tungsten content of the doped VO₂ thin films, a linear relationship was observed as shown in Figure 15. The reduction in transition temperature was approximately 19°C for each 1 atom% tungsten-doped into the VO₂ lattice and was in agreement with the results reported for tungsten-doped VO₂ thin films prepared by PVD methods [11] & [31].

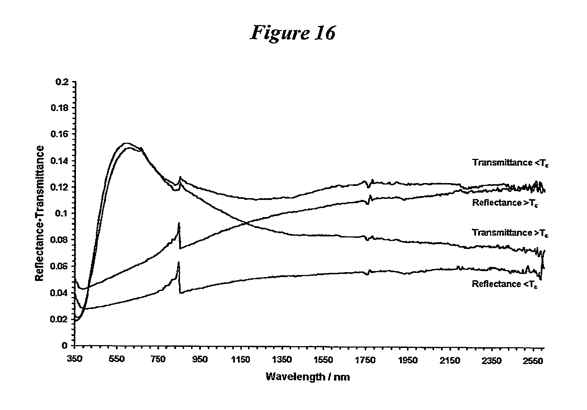

The reflectance-transmittance spectra of a 0.6 atom% tungsten-doped VO₂ thin films is shown in Figure 16. The change in transmittance properties was quite dramatic in the infrared region, with no appreciable change in the visual transmittance, when the temperature of the thin film was increased from room temperature to a temperature above which the metal-to-semiconductor transition occurred. There was an equally dramatic change in reflectance properties between the two states, at low temperature the reflectance spectrum was fairly constant over the wavelength range measured, but when the temperature was increased to above the transition temperature of the material, the reflectance of the material increased significantly, especially in the infrared region but also in the visible region. This is exactly the response required if the APCVD prepared tungsten-doped VO₂ thin films are to find use as intelligent window coatings.

### REFERENCES

[1] K.D. Rogers, Powder Diffract. (1993) 8, 240
[2] F.J. Morin, Phys. Rev. Lett. (1959) 3, 34
[3] H.W. Verleur et al., Phys. Rev. (1968) 172, 788
[4] A.W. Smith, Appl. Phys. Lett. (1973) 23, 437
[5] W.R. Roach, Appl. Phys. Lett. (1971) 19, 453
[6] M.A. Richardson et al., Optics and Laser Tech. (1998) 30, 137
[7] C.G. Granqvist, Thin Solid Films (1990), 193(194), 730
[8] C.G. Granqvist, Adv. Mater. (2003), 15, 1789
[9] C.B. Greenburg, Thin Solid Films (1983), 110, 73-82
[10] F. Béteille et al., J. Sol-Gel Sci. Technol. (1998), 13, 915
[11] W. Burkhardt et al., Thin Solid Films (1999), 345, 229
[12] M.A. Sobhan, Solar Energy Mater. Solar Cells (1996), 44, 451
[13] C.G. Granqvist, Thin Solid Films (1990), 193(194), 730
[14] C.G. Granqvist, Adv. Mater. (2003), 15, 1789
[15] T.D. Manning et al., J. Mater. Chem. (2002), 12, 2936
[16] C.G. Granqvist, Thin Solid Films (1990), 193(194), 730
[17] C.G. Granqvist, Adv. Mater. (2003), 15, 1789
[18] U. Riaz, Thin Solid Films (1993) 235, 15
[19] T. Maruyaman et al., J. Mater. Sci. (1990), 28, 5073
[20] K.F. Jensen in Chemical Vapour Deposition: Principles and Applications ed M.L. Hitchman and K.F. Jensen, Academic Press, London (1993), 35-39
[21] J.C. Parker, Phys. Rev. B (1990), 42, 3164-3166
[22] A. G. Aronov et al., Fiz. Tverd. Tela. (Leningrad) (1997), 19, 193
[23] A. G. Aronov et al., Sov. Phys. Solid State (Engl. Transl) (1997), 19, 110
[24] C. Tang et al., Phys Rev. B (1985), 31, 1000
[25] C.D Wagner et al., NIST X-ray Photoelectron Spectroscopy Database, version 3.3 (web version) (2003), http://srdata.nist.gov/xps/
[26] T.D. Manning et al., Polyhedron (2004), 23, 3037
[27] K.D. Rogers, Powder Diffraction (1993), 8, 240-244
[28] C.D Wagner et al., NIST X-ray Photoelectron Spectroscopy Database, version 3.4 (web version) (2003), http://srdata.nist.gov/xps/
[29] J. Mendialdua et al., Journal of Electron Spectroscopy and Related Phenomena (1995), 71, 249-261
[30] J.D. Lee, Concise Inorganic Chemistry, Chapman and Hall, London, 4th ed. (1995).
[31] Ping Jin et al., Japanese Journal of Applied Physics (1995), 34, 2459-2460

## Claims

1. The use of atmospheric pressure chemical vapour deposition (APCVD) for producing a film of thermochromic tungsten-doped vanadium (IV) oxide having a thermochromic switching temperature from 15°C to 40°C on a substrate, wherein a vanadium precursor, a transition metal dopant precursor and an oxygen precursor are reacted together in the APCVD reactor at a temperature of 500 °C or more and wherein the molar ratio of vanadium in the vanadium precursor to oxygen in the oxygen precursor is at most 1:1.

2. The use of claim 1 wherein the thermochromic switching temperature is from about 25°C to about 30°C.

3. A method of producing a film of thermochromic transition metal-doped vanadium (IV) oxide on a substrate by atmospheric pressure chemical vapour deposition (APCVD), comprising the steps of:
(i) reacting together (a) a vanadium precursor (b) a transition metal dopant precursor and (c) an oxygen precursor in an atmospheric pressure chemical vapour deposition (APCVD) reactor to form thermochromic transition metal-doped vanadium (IV) oxide, wherein the precursors are reacted together in the APCVD reactor at a temperature of 500 °C or more and wherein the molar ratio of vanadium in the vanadium precursor to oxygen in the oxygen precursor is at most 1:1; and
(ii) depositing the thermochromic transition metal-doped vanadium (IV) oxide onto the substrate,
**characterised in that** the transition metal dopant precursor is WCl₆.

4. The method of any of claims 1 to 3 wherein the molar ratio of transition metal in the transition metal dopant precursor to vanadium in the vanadium precursor is from about 1:25 to about 1:1.

5. The method of any of claims 1 to 4 wherein the vanadium precursor is VCl₄ or VOCl₃.

6. The method of any of claims 1 to 5 wherein the oxygen precursor is H₂O.

7. The method of any of claims 1 to 6 wherein the substrate is a glass substrate.

## Patentansprüche

1. Verwendung von APCVD (Atmospheric Pressure Chemical Vapour Deposition - CVD-Abscheidung bei Normaldruck) zum Herstellen eines Films aus thermochromem, wolframdotiertem Vanadium-(IV)-Oxid mit einer thermochromen Schalttemperatur von 15°C bis 40°C auf einem Substrat, wobei ein Vanadiumvorläufer, ein Übergangsmetalldotierstoffvorläufer und ein Sauerstoffvorläufer in dem APCVD-Reaktor bei einer Temperatur von 500°C oder mehr gemeinsam umgesetzt werden und wobei das Molverhältnis von Vanadium in dem Vanadiumvorläufer zu Sauerstoff in dem Sauerstoffvorläufer höchstens 1:1 beträgt.

2. Verwendung nach Anspruch 1, wobei die thermochrome Schalttemperatur zwischen etwa 25°C und etwa 30°C liegt.

3. Verfahren zum Herstellen eines Films aus thermochromem, übergangsmetalldotiertem Vanadium-(IV)-Oxid auf einem Substrat durch APCVD, umfassend die folgenden Schritte:
(i) miteinander Umsetzen von (a) einem Vanadiumvorläufer, (b) einem Ubergangsmetalldotierstoffvorläufer und (c) einem Sauerstoffvorläufer in einem APCVD-Reaktor zum Ausbilden von thermochromem übergangsmetalldotiertem Vanadium-(IV)-Oxid, wobei die Vorläufer in dem APCVD-Reaktor bei einer Temperatur von 500°C oder mehr zusammen umgesetzt werden und wobei das Molverhältnis von Vanadium in dem Vanadiumvorläufer zu Sauerstoff in dem Sauerstoffvorläufer höchstens 1:1 beträgt; und
(ii) Abscheiden des thermochromen übergangsmetalldotierten Vanadium-(IV)-Oxids auf dem Substrat,
**dadurch gekennzeichnet, dass** der Übergangsmetalldotierstoffvorläufer WCl₆ ist.

4. Verfahren nach einem der Ansprüche 1 bis 3, wobei das Molverhältnis von Übergangsmetall in dem übergangesmetalldotierstoffvorläufer zu Vanadium in dem Vanadiumvorläufer zwischen etwa 1:25 und etwa 1:1 liegt.

5. Verfahren nach einem der Ansprüche 1 bis 4, wobei der Vanadiumvorläufer VCl₄ oder VOCl₃ ist.

6. Verfahren nach einem der Ansprüche 1 bis 5, wobei der Sauerstoffvorläufer H₂O ist.

7. Verfahren nach einem der Ansprüche 1 bis 6, wobei das Substrat ein Glassubstrat ist.

## Revendications

1. Utilisation du dépôt chimique en phase vapeur à pression atmosphérique (APCVD) pour fabriquer un film d'oxyde de vanadium (IV) dopé au tungstène thermochromique ayant une température de commutation thermochromique de 15 °C à 40 °C sur un substrat, dans laquelle on fait réagir ensemble un précurseur de vanadium, un précurseur de dopant à base de métal de transition et un précurseur d'oxygène dans le réacteur d'APCVD à une température de 500 °C ou plus et dans laquelle le rapport molaire entre le vanadium dans le précurseur de vanadium et l'oxygène dans le précurseur d'oxygène est au maximum de 1:1.

2. Utilisation selon la revendication 1 dans laquelle la température de commutation thermochromique est d'environ 25 °C à environ 30 °C.

3. Procédé de fabrication d'un film d'oxyde de vanadium (IV) dopé par un métal de transition thermochromique sur un substrat par dépôt chimique en phase vapeur à pression atmosphérique (APCVD), comprenant les étapes consistant à :
(i) faire réagir ensemble (a) un précurseur de vanadium, (b) un précurseur de dopant à base de métal de Transition et (c) un précurseur d'oxygène dans un réacteur de dépôt chimique en phase vapeur à pression atmosphérique (APCVD) pour former un oxyde de vanadium (IV) dopé par un métal de transition thermochromique, dans lequel on fait réagir ensemble les précurseurs dans le réacteur d'APCVD à une température de 500 °C ou plus et dans lequel le rapport molaire entre le vanadium dans le précurseur de vanadium et l'oxygène dans le précurseur d'oxygène est au maximum de 1:1 ; et
(ii) déposer l'oxyde de vanadium (IV) dopé par un métal de transition thermochromique sur le substrat,
**caractérisé en ce que** le précurseur de dopant à base de métal de transition est WCl₆.

4. Procédé selon l'une quelconque des revendications 1 à 3 dans lequel le rapport molaire entre le métal de transition dans le précurseur de dopant à base de métal de transition et le vanadium dans le précurseur de vanadium est d'environ 1:25 à environ 1:1.

5. Procédé selon l'une quelconque des revendications 1 à 4 dans lequel le précurseur de vanadium est VCl₄ ou VOCl₃.

6. Procédé selon l'une quelconque des revendications 1 à 5 dans lequel le précurseur d'oxygène est H₂O.

7. Procédé selon l'une quelconque des revendications 1 à 6 dans lequel le substrat est un substrat de verre.
